# FASCICULE DE BREVET EUROPEEN

(11) **EP 0 649 567 B1**
(45) Date de publication et mention de la délivrance du brevet: **30.08.2000**
(21) Numéro de dépôt: 94915202.9
(22) Date de dépôt: 03.05.1994
(51) Int. Cl.: H01L 27/148, H01L 31/102, H01L 31/112

(54) **Photodiode**
Photodiode
Photodiode

(30) Priorité: 07.05.1993 FR 9305517
(43) Date de publication de la demande: 26.04.1995
(73) Titulaire: THOMSON-CSF SEMICONDUCTEURS SPECIFIQUES, 75008 Paris (FR)
(72) Inventeur: CARANHAC, Sophie, F-92402 Courbevoie Cédex (FR); THENOZ, Yves, F-92402 Courbevoie Cédex (FR)
(74) Mandataire: Guérin, Michel
(86) Numéro de dépôt international: FR9400506
(87) Numéro de publication internationale: WO9427322

(56) Documents cités:
- EP-A- 0 333 260
- EP-A- 0 457 192
- WO-A-91/03838
- US-A- 3 995 302
- PATENT ABSTRACTS OF JAPAN vol. 10, no. 125 (E-402) (2182) 10 Mai 1986 & JP,A,60 257 574 (MATSUSHITA DENSHI KOGYO K.K.)
- PATENT ABSTRACTS OF JAPAN vol. 11, no. 23 (E-473) (2470) 22 Janvier 1987 & JP,A,61 194 870 (NEC CORP)
- PATENT ABSTRACTS OF JAPAN vol. 12, no. 193 (E-617) (3040) 4 Juin 1988 & JP,A,62 296 463 (NEC CORP)

## Description

La présente invention concerne une photodiode.

L'invention sera plus particulièrement décrite pour la réalisation de photodiodes de grandes dimensions couplées à des registres de lecture de charges.

Les photodiodes de grandes dimensions sont destinées à fournir des signaux à faible éclairement.

Selon l'art antérieur, les charges créées dans les photodiodes de grandes dimensions ne peuvent être complètement entraînées vers le registre de lecture que si un fond de charges, dit charge d'entraînement, est injecté dans la diode.

Cette charge d'entraînement est alors transférée et lue en même temps que le signal utile créé par la photodiode. Un tel système présente de nombreux inconvénients. Outre le fait qu'il nécessite un dispositif d'injection de charges, il diminue la dynamique de sortie en augmentant le niveau de bruit.

L'invention ne présente pas ces inconvénients.

La présente invention a pour objet une photodiode constituée d'une zone photosensible permettant de générer des charges sous l'effet de la lumière et d'une grille de stockage destinée à stocker les charges ainsi générées, caractérisée en ce que la zone photosensible comprend des moyens pour drainer vers la grille de stockage les charges générées loin de cette grille, ces moyens étant constitués d'au moins une grille de drainage située sur la zone photosensible et électriquement reliée à la grille de stockage, chaque grille de drainage ayant une largeur progressivement croissante vers la grille de stockage, ladite largeur étant suffisamment étroite pour que se crée, sous ladite grille, un puits de potentiel dont la profondeur croît en se rapprochant de la grille de stockage.

Sous l'effet d'une tension continue appliquée aux grilles, un puits de potentiel de profondeur croissante apparaît sous chaque grille permettant de collecter et de drainer vers la grille de stockage les électrons créés dans la zone photosensible.

Un avantage de l'invention consiste donc à améliorer les performances électriques des diodes photoélectriques de grandes dimensions.

On notera que le document de brevet EP-A-0457192 décrit un puits de potentiel de profondeur variable sous une électrode de largeur variable à la jonction entre deux zones de stockage mais pas à l'intérieur d'une zone photosensible. Le document JP-A-61-194870 décrit une zone de stokage trapézoïdale non photosensible dans laquelle s'établit un puits de potentiel de profondeur variable. Une structure à photodiodes et grille de stockage de charges est décrite dans le document WO-A-91/03838.

D'autres caractéristiques et avantages de l'invention apparaîtront à la lecture de modes de réalisation faits avec référence aux figures ci-annexées dans lesquelles :
- La figure 1 représente le puits de potentiel existant sous une grille isolée selon deux valeurs différentes de la tension appliquée à la grille.
- La figure 2 représente les puits de potentiel existant sous trois grilles isolées étroites de largeurs différentes, selon une même valeur de la tension appliquée à la grille.
- la figure 3 représente une photodiode selon un premier mode de réalisation de l'invention ;
- la figure 4 représente une vue en coupe détaillée de la figure 3.
- la figure 5 représente une photodiode selon le mode de réalisation préférentiel de l'invention.
- la figure 6 représente une vue en coupe détaillée de la figure 5. Sur toutes les figures les mêmes repères désignent les mêmes éléments.

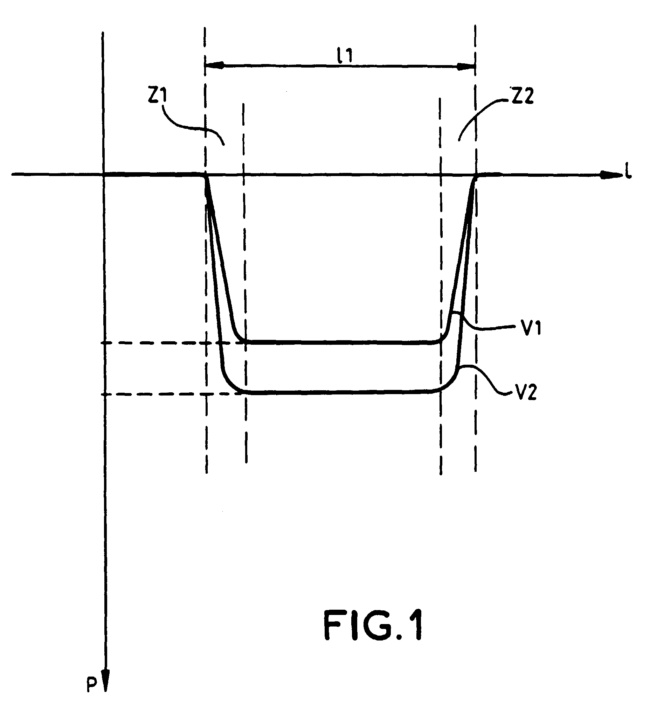

La figure 1 représente le puits de potentiel existant sous une grille isolée de largeur l1, selon deux valeurs différentes (V1, V2) de la tension appliquée à la grille.

Une première courbe C1 correspond à une tension V1 et une deuxième courbe C2 correspond à une tension V2 supérieure à V1. Comme cela est connu de l'homme de l'art, le puits de potentiel P est d'autant plus profond que la tension appliquée est élevée.

Ces puits de potentiel sont uniformes sous toute la largeur de la grille sauf dans les zones de transition Z1, Z2 situées sur les bords de la grille puisque le puits de potentiel n'atteint pas immédiatement sa valeur.

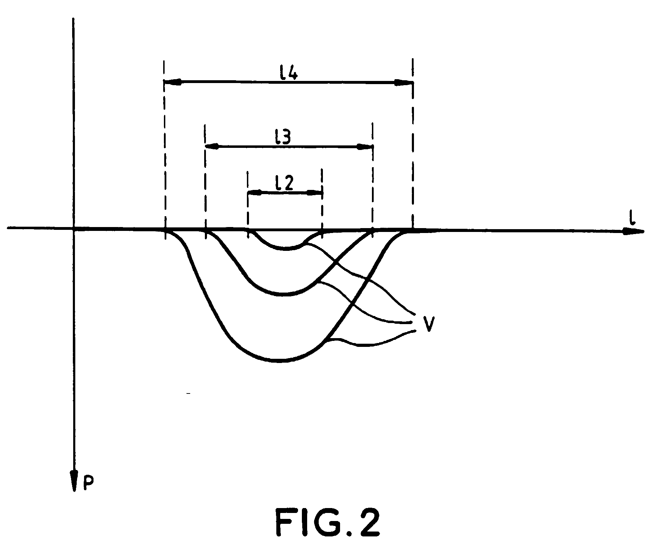

La figure 2 représente les puits de potentiel existant sous trois grilles étroites de largeurs différentes (l2, l3, l4), selon une même valeur (V) de la tension appliquée à la grille.

Les largeurs l2, l3, l4 des grilles sont de l'ordre de grandeur des zones de transition Z1, Z2 mentionnées précédemment. La largeur l4 étant supérieure à la largeur l3, elle-même supérieure à la largeur l2, le puits de potentiel créé par la grille de largeur l4 est plus profond que le puits de potentiel créé par la grille de largeur l3, ce dernier étant plus profond que le puits de potentiel créé par la grille de largeur l2. Ainsi les puits de potentiel présentent-ils, pour une même valeur de tension appliquée aux grilles, des profondeurs de plus en plus grandes au fur et à mesure que la grille s'élargit. Il est alors possible d'obtenir une différence de potentiel de quelques volts le long d'une grille de largeur étroite s'élargissant continûment et sur laquelle est appliquée une tension V.

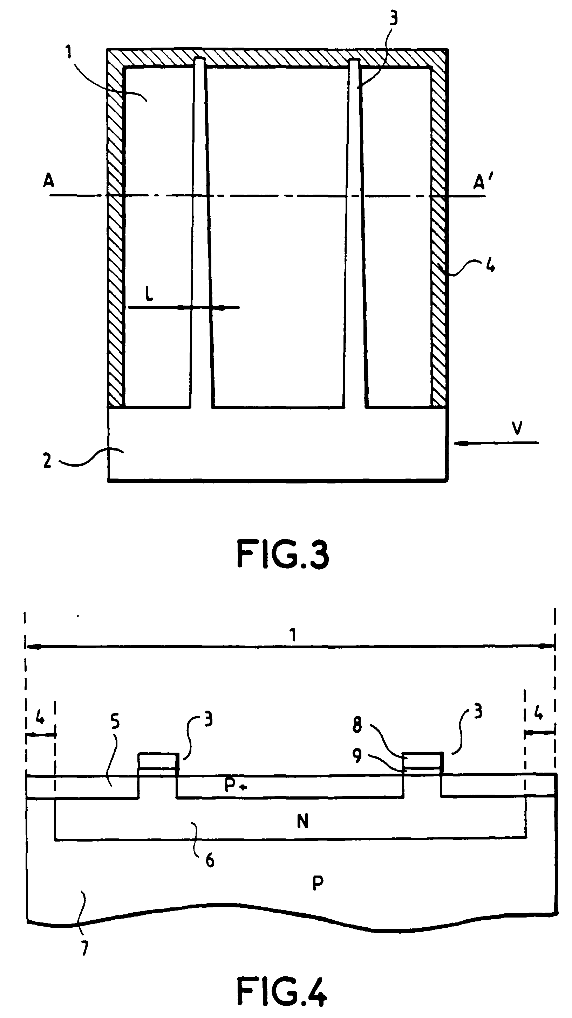

La figure 3 représente la vue de dessus d'une photodiode selon un premier mode de réalisation de l'invention.

Celle photodiode est constituée d'une zone photosensible 1 et d'une grille de stockage latérale non photosensible 2. La zone photosensible 1 est du type à faible rémanence et sera plus particulièrement décrite en figure 4. Selon l'invention la grille de stockage 2 est électriquement reliée à des grilles 3 permettant de collecter et de drainer vers la grille de stockage les électrons générés dans la zone photosensible, loin de la grille de stockage 2.

Chaque grille de drainage 3 s'élargit, de préférence continûment, de l'extrémité opposée à la grille de stockage à la zone où s'effectue le contact avec la grille de stockage. Cet élargissement est calculé de façon que se crée en dessous de la grille 3, et sous l'action de la tension extérieure V appliquée à la grille, un puits de potentiel dont la profondeur s'accroit et varie de quelques volts, par exemple 2 à 3 Volts, entre l'extrémité de la grille 3 éloignée de la grille de stockage et l'extrémité de la grille 3 qui est au contact de la grille de stockage. Les électrons qui ne sont pas générés à proximité de la grille de stockage 2 sont alors entraînés vers cette dernière par l'intermédiaire de la grille 3 la plus proche. Selon un mode de réalisation de l'invention, la largeur l de la grille 3 est de l'ordre de 2 micromètres à l'extrémité opposée à la grille de stockage 2 et de l'ordre de 3,5 micromètres là où s'effectue le contact avec ladite grille de stockage. Cependant d'autres valeurs sont possibles. Les valeurs choisies doivent alors
être compatibles de l'approfondissement désiré du puits de potentiel.

Sur la figure 3 sont représentées deux grilles de drainage d'électrons. L'invention concerne cependant des photodiodes comportant un nombre différent de grilles de drainage 3. De façon générale, le nombre de grilles de drainage est relié à la surface totale de la zone photosensible 1 et à la quantité de lumière que l'on désire détecter.

Selon le mode de réalisation préférentiel de l'invention les deux grilles de drainage sont distantes d'environ 40 micromètres ce qui correspond à un drainage des électrons sur environ 20 micromètres.

La photodiode comprend sur la périphérie qui ne jouxte pas la grille de stockage 2 une zone 4 d'isolation. Cette zone sert à isoler les zones photosensibles lorsque plusieurs photodiodes sont mises côte à côte. La zone 4 est réalisée, par exemple, par implantation directe de bore dans le substrat P, sans la présence de la couche dopée N que l'on trouve dans le reste de la zone photosensible.

La figure 4 représente une vue en coupe détaillée de la figure 3. Cette vue en coupe permet de représenter en épaisseur la diode photoélectrique selon l'invention, suivant l'axe AA' de la figure 3.

La photodiode selon l'invention est du type à faible rémanence. Comme cela est connu de l'homme de l'art la zone photosensible est constituée d'une fine couche fortement dopée P, déposée sur une couche dopée N, laquelle recouvre un substrat dopé P. Ainsi, en dehors de la partie recouverte par les grilles de drainage 3, la photodiode de l'invention est-elle constituée d'une fine couche 5 fortement dopée P (P⁺) déposée sur une couche 6 dopée N laquelle recouvre un substrat 7 dopé P.

Selon l'invention, la zone recouverte par une grille de drainage 3 est dépourvue de couche 5 fortement dopée P afin de permettre la création du puits de potentiel qui permet le drainage des électrons.

Chaque grille de drainage 3 est constituée préférentiellement d'une couche de silicium poly-cristallin 8 déposée sur une couche d'isolant 9. Selon le mode de réalisation préférentiel, chaque grille de drainage 3 est photosensible.

Comme cela a été mentionné précédemment, la photodiode comprend sur la périphérie qui ne jouxte pas la grille de stockage 2 une zone d'isolation 4 dépourvue de couche N.

Selon le mode de réalisation décrit, les grilles de drainage 3 sont perpendiculaires à la grille de stockage 2. L'invention concerne aussi d'autres configurations qui peuvent s'avérer plus aptes à drainer les électrons vers la grille de stockage.

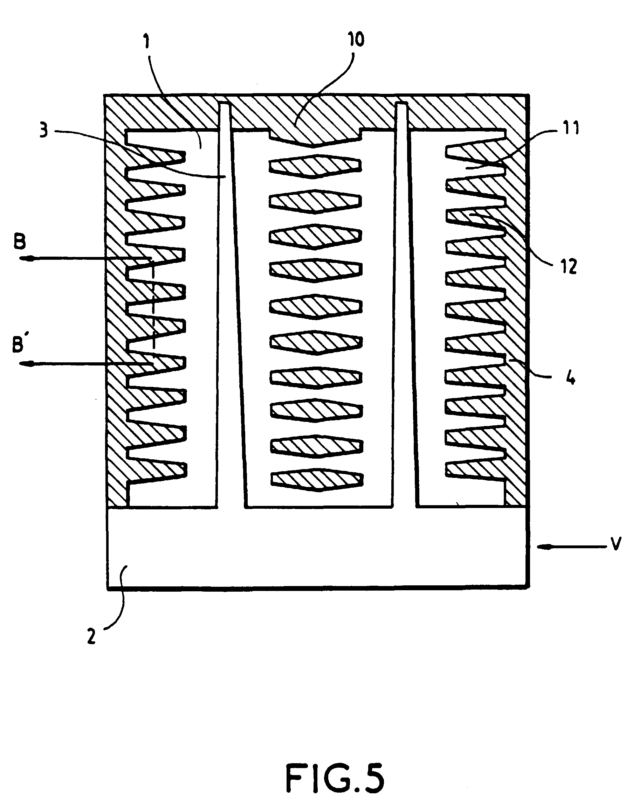

La figure 5 représente une photodiode selon le mode de réalisation préférentiel de l'invention. Selon ce mode de réalisation la géométrie de la zone photosensible 1 est découpée de façon à favoriser le parcours des électrons vers les grilles de drainage 3. A cet effet, la zone photosensible est dépourvue de couche dopée N dans toute une partie de son volume. Cette zone dépourvue de couche N est hachurée et référencée 10 sur la figure 5.

La couche dopée N se présente sous la forme d'un ensemble de canaux 11 d'axes perpendiculaires à l'axe des grilles de drainage 3 et séparés par des barrières 12 non dopées N. Chaque canal s'élargit continûment vers une grille de drainage 3. Cet élargissement est calculé préférentiellement de façon que la tension de seuil de la diode que représente la jonction P⁺/N creuse un léger puits de potentiel dont l'accentuation permet d'entraîner les électrons présents dans les canaux 11 vers les grilles de drainage 3. Les électrons engendrés dans les barrières 12 tendent à glisser vers les canaux 11 et participent ainsi au flux d'électrons drainés par les canaux 11. L'ensemble des canaux 11 constitue donc un moyen supplémentaire permettant de faciliter l'accès des électrons aux grilles de drainage 3.

Selon le mode de réalisation préférentiel, une même grille de drainage est entourée de deux sous-ensembles de canaux 11 comme représenté en figure 5.

La photodiode représentée en figure 5 comprend deux grilles de drainage 3. Comme cela a été mentionné précédemment, l'invention concerne aussi des photodiodes comportant un nombre différent de grilles de drainage.

Dans les dispositifs qui utilisent ces photodiodes, tels que les dispositifs à transfert de charge, plusieurs photodiodes sont placées côte à côte. Il est alors nécessaire d'isoler les zones photosensibles les unes des autres. Le pourtour 4 de la zone 10 dépourvue de couche N y pourvoit comme cela a été décrit précédemment.

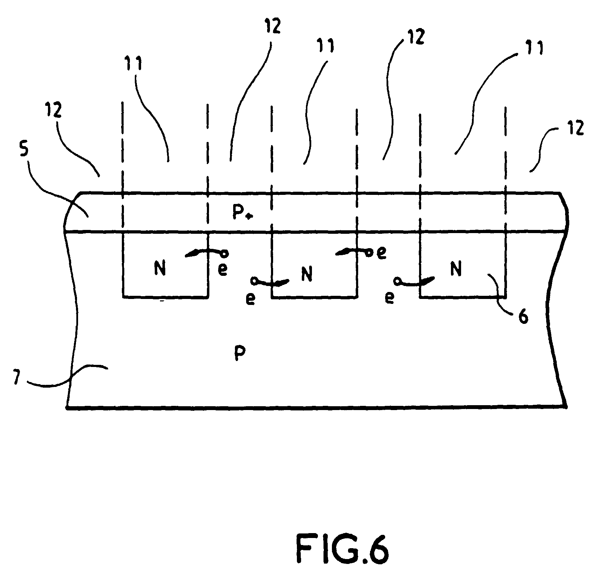

La figure 6 représente une vue en coupe détaillée de la figure 5. La coupe est effectuée suivant l'axe BB' de la figure 5.

Selon cet axe, la zone photosensible 1 est constituée d'une alternance régulière de canaux 11 et de barrières 12.

Chaque canal 11 est constitué de l'empilement d'une fine couche 5 fortement dopée P, déposée sur une couche 6 dopée N, laquelle recouvre un substrat 7 dopé P.

Chaque barrière 12 , dépourvue de couche N est constitué de la couche 5 et du substrat 7. Les électrons e générés en zone P sont symboliquement représentés comme se déversant dans la zone N la plus proche.

## Revendications

1. Photodiode constituée d'une zone photosensible (1) permettant de générer des charges sous l'effet de la lumière et d'une grille de stockage (2) destinée à stocker les charges ainsi générées, caractérisée en ce que la zone photosensible (1) comprend des moyens (3) pour drainer vers la grille de stockage (2) les charges générées loin de cette grille, ces moyens étant constitués d'au moins une grille de drainage (3) située sur la zone photosensible et électriquement reliée à la grille de stockage (2), chaque grille de drainage (3) ayant une largeur progressivement croissante vers la grille de stockage (2), ladite largeur étant suffisamment étroite pour que se crée, sous ladite grille (3), un puits de potentiel dont la profondeur croît en se rapprochant de la grille de stockage (2).

2. Photodiode selon la revendication 1, caractérisée en ce que la photodiode comporte une couche semi-conductrice dopée P⁺ située sur une couche semi-conductrice dopée N, elle-même située sur une couche semi-conductrice dopée P, en ce que chaque grille de drainage (3) est constituée d'une couche de silicium poly-cristallin (8) déposée sur une couche d'isolant (9), et en ce que la zone photosensible située sous ladite grille de drainage est dépourvue de couche P⁺.

3. Photodiode selon l'une des revendications 1 et 2, caractérisée en ce que la couche dopée N de la zone photosensible (1) se présente sous la forme d'un ensemble de canaux (11) perpendiculaires aux grilles de drainage (3) et s'élargissant progressivement du côté tourné vers une grille de drainage.

4. Photodiode selon l'une quelconque des revendications 1 à 3, caractérisée en ce que la grille de stockage jouxte la périphérie de la photodiode sur une partie seulement de celle dernière, et en ce qu'une zone isolante (4) est prévue autour de la photodiode sur le reste de ladite périphérie.

## Claims

1. Photodiode consisting of a photosensitive zone (1) enabling charges to be generated under the effect of light and of a storage gate (2) intended to store the charges thus generated, characterized in that the photosensitive zone (1) comprises means (3) for draining towards the storage gate (2) the charges generated far from this gate, these means consisting of at least one drainage gate (3) located in the photosensitive zone and electrically connected to the storage gate (2), each drainage gate (3) having a width increasing progressively towards the storage gate (2), the said width being sufficiently narrow for a potential well to be created beneath the said gate (3), the depth of the potential well increasing on moving closer to the storage gate (2).

2. Photodiode according to Claim 1, characterized in that the photodiode includes a p⁺-doped semiconductor layer located on an n-doped semiconductor layer which is itself located on a p-doped semiconductor layer, in that each drainage gate (3) consists of a polycrystalline silicon layer (8) deposited on an insulation layer (9) and in that the photosensitive zone located beneath the said drainage gate does not have a p⁺ layer.

3. Photodiode according to either of Claims 1 and 2, characterized in that the n-doped layer of the photosensitive zone (1) is in the form of a set of channels (11) perpendicular to the drainage gates (3) and widening progressively on the side turned towards a drainage gate.

4. Photodiode according to any one of Claims 1 to 3, characterized in that the storage gate adjoins the periphery of the photodiode over only part of the latter and in that an insulating zone (4) is provided around the photodiode over the rest of the said periphery.

## Patentansprüche

1. Photodiode mit einer lichtempfindlichen Zone (1), die bei Lichteinfall Ladungen erzeugen kann, und mit einem Speichergate (2), das die so erzeugten Ladungen speichern soll, dadurch gekennzeichnet, daß die lichtempfindliche Zone (1) Mittel (3) zum Transfer der fern vom Speichergate (2) erzeugten Ladungen zu diesem Gate enthält, wobei diese Mittel aus mindestens einem Kollektorgate (3) bestehen, das in der lichtempfindlichen Zone liegt und elektrisch an das Speichergate (2) angeschlossen ist sowie eine in Richtung zum Speichergate (2) zunehmende Breite besitzt, die ausreichend gering ist, um unter dem Kollektorgate (3) eine Potentialsenke entstehen zu lassen, deren Tiefe bei Annäherung an das Speichergate (2) zunimmt.

2. Photodiode nach Anspruch 1, dadurch gekennzeichnet, daß sie eine halbleitende Schicht mit P⁺-Dotierung besitzt, die sich auf einer halbleitenden Schicht mit N-Dotierung befindet, welche ihrerseits auf einer halbleitenden Schicht mit P-Dotierung liegt, daß jedes Kollektorgate (3) von einer Schicht (8) aus polykristallinem Silizium besteht, die auf eine isolierende Schicht (9) aufgebracht ist, und daß die lichtempfindliche Zone, die sich unter dem Kollektorgate befindet, keine P⁺-Dotierung aufweist.

3. Photodiode nach einem der Ansprüche 1 und 2, dadurch gekennzeichnet, daß die Schicht mit N-Dotierung der lichtempfindlichen Zone (1) die Form einer Gruppe von senkrecht zu den Kollektorgates (3) verlaufenden Kanälen (11) besitzt, die sich bei Annäherung an ein Kollektorgate zunehmend verbreitern.

4. Photodiode nach einem beliebigen der Ansprüche 1 bis 3, dadurch gekennzeichnet, daß das Speichergate nur an einem Teil des Rands der Photodiode entlang verläuft und daß eine isolierende Zone (4) am restlichen Rand um die Photodiode herum verläuft.
